# EUROPEAN PATENT APPLICATION

(11) **EP 4 797 317 A1**
(43) Date of publication of application: **26.08.2026**
(21) Application number: 24879584.1
(22) Date of filing: 03.10.2024
(51) Int. Cl.: H01L 21/3063

(54) **SUBSTRATE PROCESSING APPARATUS**

(30) Priority: 16.10.2023 JP 2023178362
(71) Applicant: SCREEN Holdings Co., Ltd., Kyoto-shi, Kyoto 602-8585 (JP)
(72) Inventor: MORITA, Kosei, Kyoto-shi, Kyoto 602-8585 (JP)
(74) Representative: Kilian Kilian & Partner mbB
(86) International application number: PCT/JP2024/035496
(87) International publication number: WO 2025/084158

(57) **Abstract**

A substrate processing apparatus (1) includes a substrate holder that holds a disk-like substrate (9), a rotation mechanism that rotates the substrate (9) together with the substrate holder, an electrode unit (5) that includes a first electrode (51) and a second electrode (52) and that is arranged at a processing position facing the substrate (9) during etching, a processing-liquid filling unit (6) that fills gaps between the substrate (9) and each of the first electrode (51) and the second electrode (52) with a processing liquid, a power source (50) that applies a voltage between the first electrode (51) and the second electrode (52), an electrode movement mechanism (73) that moves the first electrode (51) and the second electrode (52) in a direction perpendicular to main surfaces (91, 92) of the substrate (9), and a controller that acquires warpage information about the substrate (9) and controls the electrode movement mechanism (73) during etching in accordance with the warpage information and a rotation angle of the substrate (9) that is input from the rotation mechanism.

## Description

### TECHNICAL FIELD

The present invention relates to a substrate processing apparatus.

### CROSS-REFERENCE TO RELATED APPLICATIONS

This application claims priority benefit of Japanese Patent Application No. JP2023-178362 filed in the Japan Patent Office on October 16, 2023, the entire disclosure of which is incorporated herein by reference.

### BACKGROUND ART

A conventional process of manufacturing semiconductor substrates (hereinafter, simply referred to as "substrates") involves various types of processing that are performed on the substrates. For example, in the substrate processing apparatuses disclosed in Japanese Patent Application Laid-Opens No. 2021-158300 (Document 1) and No. 2023-8390 (Document 2), a processing liquid is ejected from a processing liquid supplier to multiple portions at different positions on a substrate where a noble metal film is formed, and the noble metal film on the substrate is etched as a result of the anode coming into contact with the processing liquid on one of the portions as well as the cathode coming into contact with the processing liquid on another portion.

Japanese Patent Application Laid-Open No. 2020-198339 (Document 3) discloses a substrate processing apparatus that, while rotating a substrate, holding the substrate on multiple support pins by developing a negative pressure in a space between the lower surface of the substrate and an opposing surface of an opposing member along with the rotation of the substrate. This apparatus checks whether the negative pressure is developed enough to hold the substrate on the support pins, through measurement with a positioning sensor that measures vertical positions of the upper surface of the substrate around the entire circumference along with the rotation of the substrate. International Publication No. 2022/050117 (Document 4) discloses a resist-film formation module in which an arm is provided with a resist supply nozzle and an upper-side sensor. The height of the resist supply nozzle is adjusted by moving the upper-side sensor to above a central portion of a wafer to acquire a distance between the center of the wafer and the lower end of the upper-side sensor and moving the resist supply nozzle up and down in accordance with the acquired distance.

Incidentally, substrates may be warped due to, for example, stress caused by a deposited film. In this case, if the electrodes are positioned to face a substrate during etching as disclosed in the substrate processing apparatuses according to Documents 1 and 2, the substrate and the electrodes may come into contact with each other, or the flow of the processing liquid may be interrupted between the substrate and the electrodes due an excessive increase in the distance therebetween. As a result, it may become impossible to properly perform etching on the substrate.

### SUMMARY OF THE INVENTION

The present invention is intended for a substrate processing apparatus, and it is an object of the present invention to properly perform etching on a substrate while suppressing variations in the distance between a substrate and electrodes.

Aspect 1 of the present invention is a substrate processing apparatus that performs etching on a metal film on a substrate. The substrate processing apparatus includes a substrate holder that holds a substrate having a disk-like shape, a rotation mechanism that rotates the substrate together with the substrate holder, an electrode unit that includes a first electrode and a second electrode and that is arranged at a processing position facing the substrate during etching, a processing-liquid filling unit that fills gaps between the first electrode and the substrate and between the second electrode and the substrate with a processing liquid, a power source that applies a voltage between the first electrode and the second electrode, an electrode movement mechanism that moves the first electrode and the second electrode in a direction perpendicular to main surfaces of the substrate, and a controller that acquires warpage information about the substrate and controls the electrode movement mechanism during the etching in accordance with the warpage information and a rotation angle of the substrate, the rotation angle being input from the rotation mechanism.

According to the present invention, it is possible to properly perform etching on the substrate while suppressing variations in the distance between the substrate and the electrodes.

Aspect 2 of the present invention is the substrate processing apparatus according to Aspect 1 that further includes a sensor that measures, at a predetermined circumferential position, a position of the substrate in a direction perpendicular to the main surfaces of the substrate. A measurement value obtained by the sensor is input to the controller to allow the controller to acquire the warpage information.

Aspect 3 of the present invention is the substrate processing apparatus according to Aspect 2, in which after the warpage information is acquired through measurement by the sensor while the rotation mechanism is rotating the substrate, the controller causes the substrate processing apparatus to perform the etching.

Aspect 4 of the present invention is the substrate processing apparatus according to Aspect 3, in which a circumferential position of the electrode unit arranged at the processing position is the same as a circumferential position of a measurement point on the substrate by the sensor.

Aspect 5 of the present invention is the substrate processing apparatus according to Aspect 2, in which in parallel with execution of the etching, the controller acquires the warpage information through measurement by the sensor.

Aspect 6 of the present invention is the substrate processing apparatus according to any one of Aspects 1 to 5, in which the electrode unit arranged at the processing position faces a peripheral edge portion of the substrate, and the warpage information indicates an amount of warpage of the peripheral edge portion.

Aspect 7 of the present invention is the substrate processing apparatus according to Aspect 6, in which the electrode unit arranged at the processing position faces a target portion that is part of the peripheral edge portion, and the processing-liquid filling unit forms a liquid-filled state by ejecting the processing liquid from an ejection port, the liquid-filled state being a state in which the processing liquid is filled in a space among the target portion, the first electrode, and the second electrode.

Aspect 8 of the present invention is the substrate processing apparatus according to Aspect 7, in which the first electrode and the second electrode overlap at least partly when the first electrode is located on one main surface side of the substrate, the second electrode is located on the other main surface side of the substrate, and the first electrode and the second electrode are viewed in a direction perpendicular to both of the main surfaces of the substrate.

These and other objects, features, aspects and advantages of the present invention will become more apparent from the following detailed description of the present invention when taken in conjunction with the accompanying drawings.

### BRIEF DESCRIPTION OF DRAWINGS

Fig. 1 is a diagram showing a layout of a substrate processing system.
Fig. 2 is a diagram showing a configuration of a substrate processing apparatus according to a first embodiment.
Fig. 3 is a diagram showing the vicinity of an electrode unit arranged at a processing position.
Fig. 4 is a flowchart showing substrate processing performed by the substrate processing apparatus.
Fig. 5 is a perspective view showing the electrode unit and a sensor when warpage information is acquired.
Fig. 6 is a perspective view showing the electrode unit and the sensor during etching.
Fig. 7 is a diagram for describing movement of the electrode unit by an electrode movement mechanism.
Fig. 8 is a perspective view showing the electrode unit and the sensor during etching.
Fig. 9 is a plan view showing another example of the electrode unit.
Fig. 10 is a sectional view showing another example of the electrode unit.
Fig. 11 is a sectional view showing another example of the electrode unit.
Fig. 12 is a diagram showing a substrate processing apparatus according to a second embodiment.

### DESCRIPTION OF EMBODIMENTS

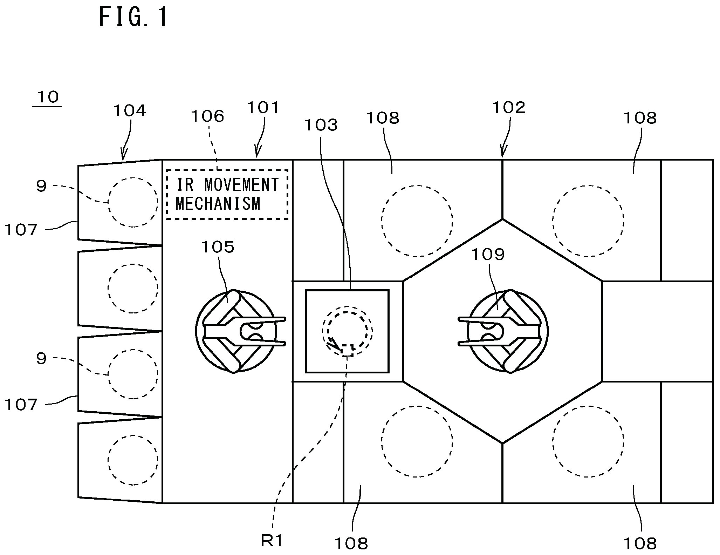

Fig. 1 is a diagram showing a layout of a substrate processing system 10. The substrate processing system 10 is a system that processes disk-like semiconductor substrates 9 (hereinafter, simply referred to as "substrates 9"). The substrate processing system 10 includes an indexer block 101 and a processing block 102 that is bonded to the indexer block 101.

The indexer block 101 includes a carrier holder 104, an indexer robot 105, and an IR movement mechanism 106. The carrier holder 104 holds a plurality of carriers 107 each capable of storing a plurality of substrates 9. The carriers 107 (e.g., FOUPs) are held by the carrier holder 104 while being aligned in a predetermined carrier alignment direction. The IR movement mechanism 106 moves the indexer robot 105 in the carrier alignment direction. The indexer robot 105 performs a transport-out operation of transporting the substrates 9 out of the carriers 107 and a transport-in operation of transporting the substrates 9 into the carriers 107. The substrates 9 are transported in a horizontal position by the indexer robot 105. A path unit 103 is provided between the indexer robot 105 and a center robot 109 in the processing block 102, which will be described later, and the indexer robot 105 transports the substrates 9 between the path unit 103 and the carriers 107. The path unit 103 temporality holds the substrates 9 in a horizontal position.

The processing block 102 includes a plurality of (e.g., four or more) processing units 108 that process the substrates 9, and the center robot 109. The processing units 108 are arranged to surround the center robot 109 in plan view. The processing units 108 perform a variety of processing on the substrates 9. A substrate processing apparatus described later corresponds to one of the processing units 108. The center robot 109 transfers the substrates 9 to and from the path unit 103. The center robot 109 also performs a transport-in operation of transporting the substrates 9 into the processing units 108 and a transport-out operation of transporting the substrates 9 out of the processing units 108. The center robot 109 also transports the substrates 9 among the processing units 108. The substrates 9 are transported in a horizontal position by the center robot 109.

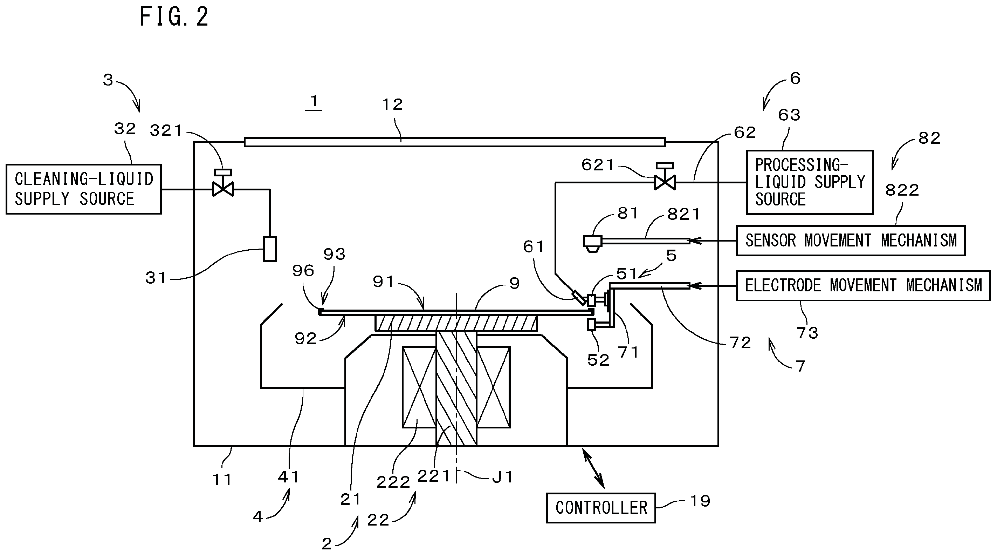

Fig. 2 is a diagram showing a configuration of a substrate processing apparatus 1 according to a first embodiment. Fig. 2 shows part of the configuration of the substrate processing apparatus 1 in cross section in a plane that includes a predetermined central axis J1. The substrate processing apparatus 1 is a single-wafer processing apparatus that processes the substrates 9 one by one, and performs electrolytic etching on a peripheral edge portion 93 of a substrate 9. The peripheral edge portion 93 of the substrate 9 includes an edge end face (apex), bevel portions, and portions located in the vicinity of the bevel portions on a first main surface 91 and a second main surface 92, which will be described later.

The substrate processing apparatus 1 includes a spin chuck 2, a cleaning-liquid supplier 3, a cup part 4, an electrode unit 5, a processing-liquid filling unit 6, an electrode mover 7, a sensor 81, a sensor mover 82, a housing 11, and a controller 19. The spin chuck 2, part of the cleaning-liquid supplier 3, the cup part 4, the electrode unit 5, part of the processing-liquid filling unit 6, part of the electrode mover 7, the sensor 81, and part of the sensor mover 82 are housed in the internal space of the housing 11. The canopy portion of the housing 11 is provided with an airflow former 12 that supplies a gas to the internal space to form an airflow flowing downward (so-called a downflow). As the airflow former 12, for example, an FFU (fan filter unit) is used. The controller 19 is arranged outside the housing 11 and controls each constituent element of the substrate processing apparatus 1. For example, the controller 19 is realized by a computer executing a predetermined program, the computer including, for example, a CPU and memory. Part or the whole of the controller 19 may be realized by, for example, a programmable logic controller (PLC).

The spin chuck 2 shown in Fig. 2 includes a chuck part 21 and a rotation mechanism 22. The chuck part 21 serves as a substrate holder that has an approximately disk-like shape centered on the central axis J1 extending approximately in parallel with the up-down direction, and that holds a substrate 9 in a horizontal position from the underside. The chuck part 21 is, for example, a vacuum chuck that contacts and adsorbs on a central portion of a lower main surface 92 of the substrate 9. Typically, the chuck part 21 has a smaller diameter than the substrate 9. The center of the substrate 9 on the chuck part 21 approximately coincides with the central axis J1. In the following description, when the substrate 9 is held in a horizontal position on the chuck part 21, its main surface 92 facing downward is referred to as the "second main surface 92", and its main surface 91 facing upward is referred to as the "first main surface 91". A radial direction and a circumferential direction that are centered on the central axis J1 are simply referred to as the "radial direction" and the "circumferential direction". The radial direction is also the radial direction of the substrate 9, and the circumferential direction is also the circumferential direction of the substrate 9.

The peripheral edge portion 93 of the substrate 9 has provided thereon a metal film 96 that is processed by the substrate processing apparatus 1. The metal film 96 has a thickness of, for example, several tens nanometers. The metal film 96 is provided on the entire or part of the peripheral edge portion 93. The metal film 96 may only need to exist at least on the peripheral edge portion 93, but it may also exist, in addition to on the peripheral edge portion 93, on a region of the first main surface 91 or the second main surface 92 that is located inward of the peripheral edge portion 93. The metal film 96 may spread approximately across the first or second main surface 91 or 92 of the substrate 9. In Fig. 2, the metal film 96 is indicated by thick lines. The metal film 96 contains, for example, ruthenium (Ru). Other than a film made from ruthenium alone, the metal film 96 may also be a film that contains a compound of ruthenium. The metal film 96 may also be a film that contains a metal other than ruthenium. In the present embodiment, it is assumed that the metal film 96 contains ruthenium.

The rotation mechanism 22 is arranged below the chuck part 21. The rotation mechanism 22 rotates the substrate 9 together with the chuck part 21 about the central axis J1. The rotation mechanism 22 includes a shaft 221 and a motor 222. The shaft 221 is an approximately columnar or cylindrical member centered on the central axis J1. The shaft 221 extends in the up-down direction and is connected to a central portion of the lower surface of the chuck part 21. The motor 222 is an electric rotary motor that rotates the shaft 221. The rotation mechanism 22 may also be a motor having a different structure (e.g., a hollow motor). The rotation mechanism 22 includes a rotary encoder and outputs a signal indicating the rotation angle of the chuck part 21 and the substrate 9 (e.g., the rotation angle of a notch of the substrate 9 with a predetermined circumferential position as a reference) to the controller 19 at specified intervals.

The cleaning-liquid supplier 3 includes a cleaning-liquid nozzle 31 and a cleaning-liquid supply source 32. The cleaning-liquid nozzle 31 is supported by a nozzle movement mechanism, which is not shown. The nozzle movement mechanism includes, for example, a motor and a ball screw and moves the cleaning-liquid nozzle 31 approximately horizontally between a supply position located above the substrate 9 and a retracted position located radially outward of the substrate 9. The cleaning-liquid nozzle 31 is connected to the cleaning-liquid supply source 32 via a cleaning liquid line provided with a valve 321. The cleaning-liquid supply source 32 supplies the cleaning liquid to the cleaning-liquid nozzle 31. The cleaning liquid is, for example, pure water such as DIW (deionized water). The cleaning liquid may also be an organic solvent such as IPA or any other type of liquid.

The cup part 4 includes a cup 41 and a cup elevating mechanism, which is not shown. The cup 41 is a ring-shaped member centered on the central axis J1. The cup 41 is arranged around the entire circumferences of the substrate 9 and the chuck part 21 and covers the sides and bottoms of the substrate 9 and the chuck part 21. The cup 41 is a liquid-receiving container that receives a liquid scattered from the rotating substrate 9 to the surroundings. The inner surface of the cup 41 is formed of, for example, a water-repellent material. The cup 41 remains stationary in the circumferential direction, regardless of whether the substrate is rotating or remains stationary. The bottom of the cup 41 is provided with a drain port (not shown) through which the liquid received by the cup 41 is discharged to the outside of the housing 11.

The cup elevating mechanism moves the cup 41 relative to the chuck part 21 in the up-down direction. The cup elevating mechanism includes a driving source such as a motor or an air cylinder. The cup elevating mechanism is capable of moving the cup 41 between a processing position that is a position located around the substrate 9 shown in Fig. 2 and a retracted position located downward of the processing position. The cup part 4 may include multiple cups 41 stacked one above another in the radial direction. In the case where the cup part 4 includes multiple cups 41, each of the cups 41 is independently movable in the up-down direction and is used to receive a liquid by switching among the cups 41 depending on the type of the liquid scattered from the substrate 9.

The electrode unit 5 includes a first electrode 51 and a second electrode 52. The first electrode 51 and the second electrode 52 each have a rod-like or columnar shape extending in the up-down direction. Each of the electrodes 51 and 52 has a diameter of, for example, greater than or equal to 2 mm and less than or equal to 20 mm, and preferably less than or equal to 4 mm. Examples of the material for each of the electrodes 51 and 52 include platinum (Pt) and glassy carbon (glassy-state carbon). As the material for the electrodes 51 and 52, any other conductive material that allows appropriate execution of etching, which will be described later, may be used.

As described later, the electrode unit 5 is supported by the electrode mover 7 and arranged at a processing position facing part of the peripheral edge portion 93 during etching of the peripheral edge portion 93 of the substrate 9. With the electrode unit 5 arranged at the processing position, the first electrode 51 is located on the side of the first main surface 91 of the substrate 9, and the second electrode 52 is located on the side of the second main surface 92 of the substrate 9. In the present embodiment, the first electrode 51 and the second electrode 52 are approximately of the same size and arranged at the same position when viewed in the up-down direction. That is, in plan view, approximately the entire first electrode 51 overlaps with the entire second electrode 52. As described later, etching of the metal film 96 is performed on a portion of the peripheral edge portion 93 that faces the electrode unit 5. Thus, this portion is hereinafter referred to as the "target portion".

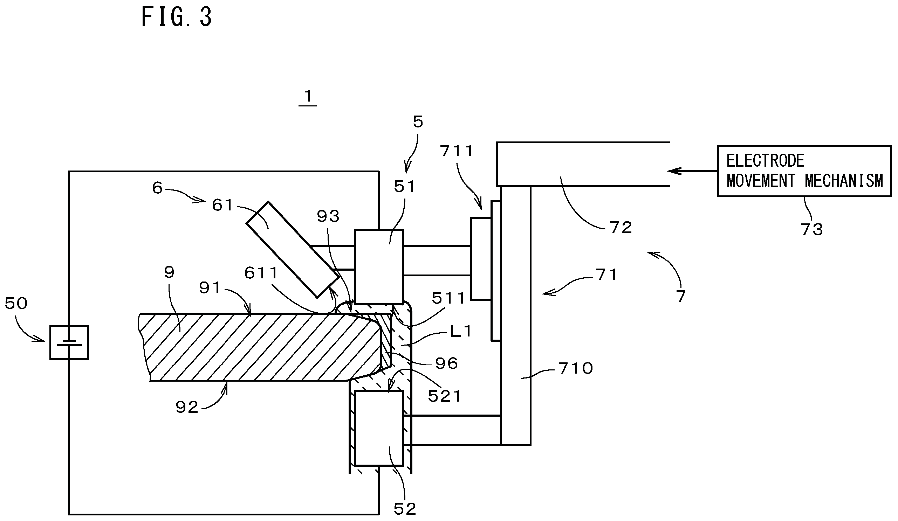

Fig. 3 is a diagram showing the vicinity of the electrode unit 5 arranged at the processing position. Fig. 3 shows the substrate 9 in cross section (in cross section in a plane including the central axis J1). With the electrode unit 5 arranged at the processing position, a downward face 511 of the first electrode 51 is approximately parallel to the first main surface 91 of the substrate 9 and faces the peripheral edge portion 93 on the side of the first main surface 91 of the substrate 9. An upward face 521 of the second electrode 52 is approximately parallel to the second main surface 92 of the substrate 9 and faces the peripheral edge portion 93 on the side of the second main surface 92 of the substrate 9. In the following description, the face 511 of the first electrode 51 and the face 521 of the second electrode 52 are referred to as the "opposing faces 511 and 521". In the example shown in Fig. 3, the opposing faces 511 and 521 are both circular. The first electrode 51 and the second electrode 52 are electrically connected to a power source 50. During etching of the peripheral edge portion 93, as described later, the processing-liquid filling unit 6 fills a space among the target portion of the peripheral edge portion 93, the first electrode 51, and the second electrode 52 with a processing liquid L1, and a predetermined voltage is applied between the first electrode 51 and the second electrode 52.

As shown in Fig. 2, the processing-liquid filling unit 6 includes a processing liquid nozzle 61, a processing liquid line 62, and a processing-liquid supply source 63. The processing liquid nozzle 61 is supported together with the electrode unit 5 by the electrode mover 7. The processing liquid nozzle 61 is connected to the processing-liquid supply source 63 via the processing liquid line 62. The processing-liquid supply source 63 supplies a processing liquid to the processing liquid nozzle 61. The processing liquid line 62 is provided with a valve 621. As shown in Fig. 3, the processing liquid nozzle 61 is arranged radially inward of the first electrode 51 on the side of the first main surface 91 of the substrate 9. The processing liquid nozzle 61 is inclined relative to the up-down direction so that its lower end provided with an ejection port 611 is located radially outward of its upper end. The ejection port 611 opens toward the gap between the first electrode 51 and the peripheral edge portion 93. During etching of the peripheral edge portion 93, the processing liquid L1 is ejected from the ejection port 611 toward the gap.

The processing liquid L1 is typically an electrolytic solution and is, for example, an aqueous solution that contains a solute such as hydrogen chloride (HCl) or ammonium chloride (NH₄Cl). The concentration of the solute is, for example, higher than or equal to 5 wt% and preferably higher than or equal to 10 wt%. There are no particular limitations on the upper limit for the concentration of the solute, but the upper limit is, for example, 25 wt%. The electrolytic solution may contain an additive or the like. The electrolytic solution may also be nonaqueous.

As shown in Fig. 2, the electrode mover 7 includes a supporter 71, an arm part 72, and an electrode movement mechanism 73. The supporter 71 supports the processing liquid nozzle 61, the first electrode 51, and the second electrode 52. To be more specific, the supporter 71 includes a supporter body 710 and an auxiliary movement mechanism 711 as shown in Fig. 3. The second electrode 52 is fixedly attached to the supporter body 710. The auxiliary movement mechanism 711 includes a fixed unit and a mobile unit. The fixed unit is fixedly attached to the supporter body 710. The mobile unit is movable relative to the fixed unit in the up-down direction. The mobile unit is fixedly attached to the processing liquid nozzle 61 and the first electrode 51. In this way, the supporter 71 supports the processing liquid nozzle 61, the first electrode 51, and the second electrode 52 while being capable of moving the processing liquid nozzle 61 and the first electrode 51 relative to the second electrode 52 in the up-down direction. The auxiliary movement mechanism 711 includes, for example, a motor and a ball screw. The auxiliary movement mechanism 711 may be realized by, for example, a linear motor.

The arm part 72 is a member that extends in the radial direction. One end of the arm part 72 is attached to the supporter 71, and the other end is supported by the electrode movement mechanism 73. The electrode movement mechanism 73 includes, for example, a motor and a ball screw and is capable of moving the arm part 72 in the radial direction (the longitudinal direction of the arm part 72) and the up-down direction. In other words, the electrode movement mechanism 73 moves the electrode unit 5 and the processing liquid nozzle 61 in the radial direction and the up-down direction. During etching of the peripheral edge portion 93, the electrode movement mechanism 73 arranges the electrode unit 5 and the processing liquid nozzle 61 at processing position facing part of the peripheral edge portion 93 of the substrate 9 (i.e., the target portion). When the etching is completed, the electrode unit 5 and the processing liquid nozzle 61 are arranged at the retracted position located radially outward of the substrate 9. The electrode movement mechanism 73 may be realized by, for example, a linear motor.

The sensor 81 shown in Fig. 2 is a non-contact positioning sensor or a distance sensor and is arranged facing the first main surface 91 of the substrate 9 at a predetermined circumferential position. The sensor 81 emits light toward the first main surface 91 of the substrate 9 and also receives reflected light of the emitted light from the first main surface 91. In this way, a position in the up-down direction perpendicular to the main surfaces 91 and 92 (i.e., a position in the up-down direction with the sensor 81 as a reference) is measured for a measurement point where the light is emitted. A measurement value obtained by the sensor 81 is output to the controller 19. The sensor 81 may also be configured to use ultrasound or the like for this measurement. Depending on the design of the substrate processing apparatus 1, the sensor 81 may be arranged facing the second main surface 92 of the substrate 9.

The sensor mover 82 includes an arm part 821 and a sensor movement mechanism 822. The arm part 821 is a member extending in a direction perpendicular to the central axis J1. One end of the arm part 821 is attached to the sensor 81, and the other end is supported by the sensor movement mechanism 822. The sensor movement mechanism 822 includes, for example, a motor and a ball screw and is capable of moving the arm part 821 together with the sensor 81 in a direction along the main surfaces 91 and 92 of the substrate 9. In the example shown in Fig. 2, the sensor movement mechanism 822 moves the sensor 81 in two directions that are perpendicular to the central axis J1 and orthogonal to each other. The sensor movement mechanism 822 may be realized by, for example, a linear motor.

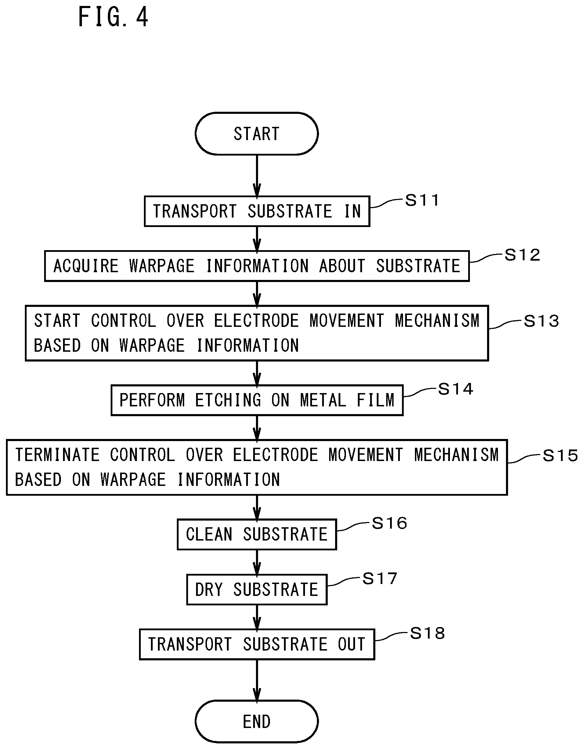

Next, a procedure for processing performed on the substrate 9 by the substrate processing apparatus 1 is described with reference to Fig. 4. In the processing performed on the substrate 9, each constituent element is controlled by the controller 19 shown in Fig. 2. Firstly, the substrate 9 with the metal film 96 formed thereon is transported into the substrate processing apparatus 1 and placed on the chuck part 21 (step S11). The substrate 9 is held on the chuck part 21 by vacuum suction. At this time, the electrode unit 5 and the processing liquid nozzle 61 are arranged at the retracted position that do not inhibit the transport of the substrate 9. The same also applies to the cleaning-liquid nozzle 31. Note that, after the transport of the substrate 9, cleaning processing (pre-cleaning) of the substrate 9 may also be performed in the same manner as in step S16, which will be described later.

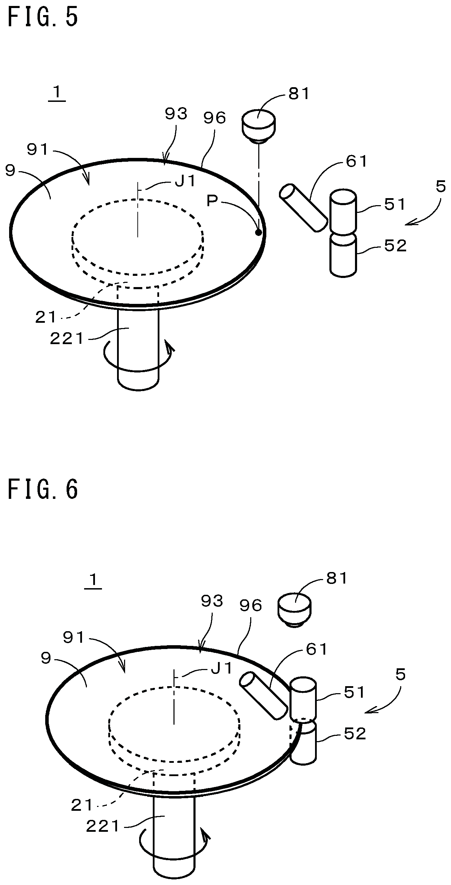

When the substrate 9 is held, the rotation mechanism 22 starts to rotate the substrate 9 at a predetermined rotational speed. As shown in Fig. 5, the sensor 81 is arranged above the peripheral edge portion 93 of the substrate 9, and a measurement point P by the sensor 81 is set on the peripheral edge portion 93 of the substrate 9. The measurement point P on the peripheral edge portion 93 is moved relative to the substrate 9 in the circumferential direction by the rotation of the substrate 9, and the position of the measurement point on the peripheral edge portion 93 in the up-down direction is measured around the entire circumference by the sensor 81. The measurement value obtained by the sensor 81 is input to the controller 19. The controller 19 also receives input of a value of the rotation angle of the substrate 9 (encoder signal) from the rotation mechanism 22.

The controller 19 has set therein, as a reference value, a preset measurement value that is obtained by the sensor 81 when no warpage occurs in the substrate 9 held on the chuck part 21, and treats a difference between the reference value and an actual measurement value obtained by the sensor 81 as the amount of warpage of the substrate 9 at the measurement point P. The sensor 81 substantially serves as a warpage-amount measurement unit that measures the amount of warpage of the substrate 9. Each measurement value obtained by the sensor 81 is associated with the value of the rotation angle of the substrate 9 obtained when this measurement value is acquired. In this way, warpage information is acquired, which indicates each value of the rotation angle of the substrate 9 and the amount of warpage of the peripheral edge portion 93 at the measurement point P associated with this value of the rotation angle (step S12). When the warpage information has been acquired, the rotation of the substrate 9 is stopped, and the measurement by the sensor 81 terminates. The amount of warpage of the peripheral edge portion 93 associated with each value of the rotation angle of the substrate 9 may, for example, be an average value of multiple measurement values obtained by the sensor 81 through multiple rotations of the substrate 9.

Then, the electrode movement mechanism 73 moves the arm part 72 to arrange the electrode unit 5 and the processing liquid nozzle 61 at the processing position. Accordingly, the electrode unit 5 and the processing liquid nozzle 61 face the target portion of the peripheral edge portion 93 of the substrate 9 as shown in Fig. 6. At this time, the first electrode 51 and the second electrode 52 are located almost immediately under the sensor 81, and a circumferential position of the electrode unit 5 arranged at the processing position is the same as a circumferential position of the measurement point P by the sensor 81 on the substrate 9. In the example shown in Fig. 6, radial positions of the electrode unit and the measurement point are also approximately the same. The auxiliary movement mechanism 711 shown in Fig. 3 separates the first electrode 51 and the second electrode 52 by a set distance, and the distances between the substrate 9 (the peripheral edge portion 93 thereof) and each of the opposing face 511 of the first electrode 51 and the opposing face 521 of the second electrode 52 are less than or equal to several millimeters. For example, in the case where the set distance is 1 mm and the thickness of the substrate 9 is 0.8 mm, the distance between the substrate 9 and each of the electrodes 51 and 52 is 0.1 mm.

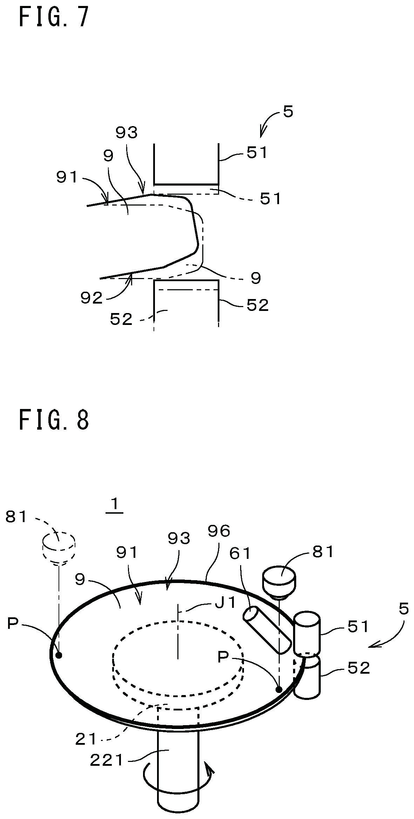

When the electrode unit 5 has been arranged at the processing position, the rotation mechanism 22 resumes the rotation of the substrate 9. In parallel with the rotation of the substrate 9, the controller 19 starts to control the electrode movement mechanism 73 in accordance with the warpage information (step S13). Specifically, the electrode movement mechanism 73 is controlled such that, with timing when each value of the rotation angle is input from the rotation mechanism 22 to the controller 19, the electrode unit 5 is moved in the up-down direction by the amount of warpage associated with this value of the rotation angle in the warpage information. For example, in the case where the amount of warpage indicates upward warpage, the first electrode 51 and the second electrode 52 are moved upward as shown in Fig. 7. In Fig. 7, the position of the substrate 9 with no warpage and the positions of the first electrode 51 and the second electrode 52 relative to this substrate 9 are indicated by chain double-dashed lines. In the case where the amount of warpage indicates downward warpage, the electrode unit 5 is moved downward. In actuality, the value of the rotation angle of the substrate 9 is input in minute cycles from the rotation mechanism 22 to the controller 19. Thus, the electrode movement mechanism 73 almost continuously moves the electrode unit 5 in the up-down direction. As a result, the distances between the substrate 9 and each of the opposing face 511 of the first electrode 51 and the opposing face 521 of the second electrode 52 are maintained approximately constant.

Then, the valve 621 in the processing liquid line 62 shown in Fig. 2 is opened, so that the processing liquid L1 is ejected from the ejection port 611 of the processing liquid nozzle 61 toward the gap between the first electrode 51 and the peripheral edge portion 93. As shown in Fig. 3, the processing liquid L1 enters and fills the gap between the first electrode 51 and the peripheral edge portion 93. Part of the processing liquid L1 may flow radially outward around this gap. The processing liquid L1 also flows around to the side of the second main surface 92 of the peripheral edge portion 93 and fills the gap between the second electrode 52 and the peripheral edge portion 93 via capillary action. This produces a liquid-filled state in which the processing liquid L1 is filled in a space among the target portion of the peripheral edge portion 93, the first electrode 51, and the second electrode 52. In the liquid-filled state, the processing liquid L1 is continuous among the target portion, the first electrode 51, and the second electrode 52 without interruption. In actuality, on each of the first and second main surfaces 91 and 92 of the substrate 9, the processing liquid L1 also slightly spreads radially inward from the gaps between the substrate 9 and each of the electrodes 51 and 52. Such an excess amount of the processing liquid L1 flows downward and is collected by the cup 41. As long as the liquid-filled state is maintained, the processing liquid L1 may be supplied either continuously or intermittently from the processing liquid nozzle 61 to the peripheral edge portion 93.

Then, the power source 50 applies a predetermined voltage between the first electrode 51 and the second electrode 52. In the example shown in Fig. 3, a higher potential is applied to the second electrode 52 than to the first electrode 51, so that the first electrode 51 serves as a cathode and the second electrode 52 serves as an anode. Through the application of the voltage to the electrode unit 5, etching is performed on the metal film 96 on the target portion of the peripheral edge portion 93 (step S14). In actuality, a portion of the metal film 96 that is located in close proximity to the cathode is preferentially etched. The reason why the metal film 96 is etched is not clear, but for example, it is presumed that the following chemical reactions occur between the first electrode 51 and the second electrode 52.

On the opposing face 511 of the first electrode 51, a chemical reaction expressed by Expression (1) occurs.

2H⁺ + 2e⁻→H₂ ... (1)

On the side of the first electrode 51 of the metal film 96, chemical reactions expressed by Expression (2), (3), and (4) occur.

Ru→Ru³⁺ + 3e⁻ ... (2)

2Cl⁻→Cl₂ + 2e⁻ ... (3)

2H₂O→O₂ + 4H⁺ + 4e⁻ ... (4)

Accordingly, the metal film 96 dissolves in the processing liquid L1.

On the side of the second electrode 52 of the metal film 96, a chemical reaction expressed by Expression (5) occurs.

2H⁺ + 2e⁻→H₂ ... (5)

On the opposing face 521 of the second electrode 52, chemical reactions expressed by Expressions (6) and (7) occur.

2Cl⁻→Cl₂ + 2e⁻ • • • (6)

2H₂O→O₂ + 4H⁺ + 4e⁻ • • • (7)

In experiments in which the processing liquid is filled in the space among the metal film, the first electrode, and the second electrode, and a voltage is applied to the processing liquid via the first electrode and the second electrode, it is confirmed that the metal film has been actually etched.

As described previously, the substrate 9 rotates relative to the electrode unit 5, and the target portion of the peripheral edge portion 93 moves in the circumferential direction relative to the substrate 9. Thus, the metal film 96 is etched around the entire circumference of the peripheral edge portion 93. An image capturer not shown is provided above the peripheral edge portion 93 of the substrate 9 to acquire images of the peripheral edge portion 93 around the entire circumference. The images of the peripheral edge portion 93 are input to the controller 19 to check the state of the peripheral edge portion 93. Specifically, it is checked whether the metal film 96 has been removed from the entire peripheral edge portion 93. The presence or absence of the metal film 96 on the peripheral edge portion 93 can be acquired using a known inspection algorithm. The presence or absence of the metal film 96 may also be checked using any other technique. For example, the presence or absence of the metal film 96 may be detected by measuring current flowing between the second electrode 52 and the first electrode 51.

When the metal film 96 has been removed from the entire peripheral edge portion 93, the application of the voltage between the electrodes 51 and 52 and the ejection of the processing liquid L1 from the processing liquid nozzle 61 are stopped, and the etching terminates. The rotation of the substrate 9 is also stopped, and the control over the electrode movement mechanism 73 based on the warpage information terminates (step S15). Thereafter, the electrode movement mechanism 73 moves the arm part 72 radially outward, so that the electrode unit 5 and the processing liquid nozzle 61 are moved away from the peripheral edge portion 93 to the retracted position. Note that the electrode unit 5 may be moved to the retracted position while maintaining the rotation of the substrate 9. In this case, the control over the electrode movement mechanism 73 based on the warpage information continues until the electrode unit 5 is moved away from the substrate 9.

Then, the rotation of the substrate 9 is resumed, and the cleaning-liquid nozzle 31 is arranged at a supply position above the substrate 9. Then, a cleaning liquid is supplied from the cleaning-liquid nozzle 31 toward a central portion of the first main surface 91 of the substrate 9. The cleaning liquid spreads across the entire first main surface 91 of the substrate 9, and cleaning processing is performed to rinse the processing liquid L1 or the like adhering to the peripheral edge portion 93 of the substrate 9 (step S16). The cleaning liquid is scattered radially outward from the peripheral edge portion 93 of the substrate 9 by centrifugal force caused by the rotation of the substrate 9, and is collected by the cup 41. Note that the cleaning-liquid nozzle 31 may eject the cleaning liquid toward the peripheral edge portion 93. As another alternative, another nozzle may be provided for ejecting a cleaning liquid onto the peripheral edge portion 93 on the side of the second main surface 92.

After the cleaning processing is performed on the substrate 9 for a predetermined amount of time, the supply of the cleaning liquid from the cleaning-liquid nozzle 31 to the substrate 9 is stopped. Then, the rotational speed of the substrate 9 is increased so as to shake off and remove the cleaning liquid off the substrate 9. That is, dry processing is performed on the substrate 9 (step S17). When the dry processing performed on the substrate 9 is completed, the rotation of the substrate 9 is stopped. Thereafter, the substrate 9 is transported out of the substrate processing apparatus 1 (step S18). Through the processing described above, the processing performed on the substrate 9 by the substrate processing apparatus 1 is completed.

In the above-described processing example, the electrode unit 5 arranged at the processing position and the measurement point P by the sensor 81 are located at the same circumferential position, but they may be shifted from each other in the circumferential direction (see Fig. 8, which will be described later). In this case, the control over the electrode movement mechanism 73 based on the warpage information uses the amount of warpage that corresponds to the value of a rotation angle that is shifted by the amount of difference (angle) in the circumferential position between the electrode unit and the measurement point from the value of the rotation angle of the substrate 9 that is put from the rotation mechanism 22. In the case where the electrode unit and the measurement point are located at different circumferential positions, the measurement by the sensor 81 may be conducted while the electrode unit 5 is arranged at the processing position. In this case, it is preferable that the auxiliary movement mechanism 711 increases the distance between the first electrode 51 and the second electrode 52 to be greater than the set distance during etching. This avoids contact between the substrate 9 and the electrodes 51 and 52 during the measurement by the sensor 81.

As described thus far, the substrate processing apparatus 1 shown in Fig. 2 includes the substrate holder (in the above description, the chuck part 21), the rotation mechanism 22, the electrode unit 5, the processing-liquid filling unit 6, the power source 50, the electrode movement mechanism 73, and the controller 19. The substrate holder holds a disk-like substrate 9. The rotation mechanism 22 rotates the substrate 9 together with the substrate holder. The electrode unit 5 includes the first electrode 51 and the second electrode 52 and is arranged at the processing position facing the substrate 9 during etching. The processing-liquid filling unit 6 fills the processing liquid L1 in the gaps between the substrate 9 and each of the first electrode 51 and the second electrode 52. The power source 50 applies a voltage between the first electrode 51 and the second electrode 52. The electrode movement mechanism 73 moves the first electrode 51 and the second electrode 52 in a direction perpendicular to the main surfaces 91 and 92 of the substrate 9 (in the present example, in the up-down direction). The controller 19 acquires the warpage information about the substrate 9 and controls the electrode movement mechanism 73 during etching in accordance with the warpage information and the rotation angle of the substrate 9 that is input from the rotation mechanism 22.

Here, a substrate processing apparatus according to a comparative example is considered, in which the control over the electrode movement mechanism 73 based on the warpage information is omitted. In the case where a substrate 9 is warped in the substrate processing apparatus according to the comparative example, the distances between the substrate 9 and each of the electrodes 51 and 52 vary, which makes it difficult to properly perform etching on the substrate 9. Specifically, the substrate 9 may come into contact with the electrode 51 or 52, or the processing liquid L1 may be discontinuous (the electrical connection breaks) between the substrate 9 and the electrode 51 or 52 due to an excessive increase in the distance therebetween. In contrast, the substrate processing apparatus 1 shown in Fig. 2 performs control over the electrode movement mechanism 73 in accordance with the warpage information. This suppresses variations in the distances between the substrate 9 and each of the electrodes 51 and 52 and allows proper etching to be performed on the substrate 9.

Preferably, the substrate processing apparatus 1 may further include the sensor 81 that measures, at a predetermined circumferential position, the position of the substrate 9 in a direction perpendicular to the main surfaces 91 and 92 of the substrate 9. As a result of inputting the measurement value obtained by the sensor 81 to the controller 19, the controller 19 can acquire the warpage information described above. In this way, through the measurement of the amount of warpage of the substrate 9 held on the substrate holder via the sensor 81, it is possible to more reliably suppress variations in the distances between the substrate 9 and each of the electrodes 51 and 52.

Preferably, after the warpage information is acquired through measurement by the sensor 81 while the rotation mechanism 22 is rotating the substrate 9, the controller 19 causes the substrate processing apparatus to perform etching. In this way, by acquiring the warpage information in advance, it is possible to accurately control the electrode movement mechanism 73 in accordance with the warpage of the substrate 9 and to more reliably suppress variations in the distances between the substrate 9 and each of the electrodes 51 and 52 even if the rotational speed of the substrate 9 during etching is relatively high.

Preferably, the circumferential position of the electrode unit 5 arranged at the processing position is the same as the circumferential position of the measurement point P by the sensor 81 on the substrate 9. In this way, if there is no circumferential positional shift between the electrode unit 5 arranged at the processing position and the measurement point P by the sensor 81, it is possible to easily control the electrode movement mechanism 73 in accordance with the warpage information. If the radial positions of the electrode unit and the measurement point are also approximately the same, it is possible to measure the amount of warpage of the substrate 9 at the position where the electrode unit 5 is arranged and to more reliably suppress variations in the distances between the substrate 9 and each of the electrodes 51 and 52. In the substrate processing apparatus 1, when viewed in a direction perpendicular to the main surfaces 91 and 92 of the substrate 9, the electrode movement mechanism 73 is capable of changing the position of the electrode unit 5, and during measurement by the sensor 81, the electrode unit 5 is arranged at a position away from the measurement point P by the sensor 81 as described previously. The electrode unit 5 arranged at the processing position and the measurement point P by the sensor 81 may be arranged at different radial positions.

The next description is given about another processing example of the substrate processing apparatus 1. In this other processing example, the substrate processing apparatus performs etching on the metal film 96 on the substrate 9 while acquiring the warpage information about the substrate 9. Specifically, when the substrate 9 is transported into the substrate processing apparatus 1 and placed on the chuck part 21 (Fig. 4 : step S11), the electrode movement mechanism 73 arranges the electrode unit 5 and the processing liquid nozzle 61 at the processing position. Accordingly, the electrode unit 5 and the processing liquid nozzle 61 face the target portion of the peripheral edge portion 93 of the substrate 9 as shown in Fig. 8. After the rotation mechanism 22 has started the rotation of the substrate 9, the processing liquid L1 is ejected from the processing liquid nozzle 61 so as to form a liquid-filled state in which the processing liquid L1 is filled in the space among the target portion, the first electrode 51, and the second electrode 52. The electrode unit 5 and the processing liquid nozzle 61 may be arranged at the processing position after the start of the rotation of the substrate 9.

Moreover, the sensor mover 82 arranges the sensor 81 above the peripheral edge portion 93 at a predetermined circumferential position so that the circumferential position of the measurement point P by the sensor 81 is shifted from the circumferential position of the electrode unit 5 arranged at the processing position. In the example shown in Fig. 8, the measurement point P by the sensor 81 is set at a position that is in close proximity to the upstream side in the direction of rotation of the substrate 9 with respect to the electrode unit 5. In parallel with the rotation of the substrate 9, the sensor 81 measures the position of the peripheral edge portion 93 in the up-down direction. Each measurement value obtained by the sensor 81 is associated with the value of the rotation angle of the substrate 9 obtained when this measurement value is acquired. In this way, warpage information is acquired, which indicates each value of the rotation angle of the substrate 9 and the amount of warpage of the peripheral edge portion 93 at the measurement point P associated with this value of the rotation angle (step S12)

In parallel with the acquisition of the warpage information, the controller 19 controls the electrode movement mechanism 73 in accordance with the warpage information (step S13). As described previously, the circumferential position of the electrode unit 5 arranged at the processing position is shifted from the circumferential position of the measurement point P by the sensor 81. Thus, the control over the electrode movement mechanism 73 based on the warpage information uses the amount of warpage that corresponds to the value of a rotation angle that is shifted by the amount of difference (angle) in the circumferential position between the electrode unit and the measurement point from the value of the rotation angle of the substrate 9 that is input from the rotation mechanism 22.

In parallel with the acquisition of the warpage information and the control over the electrode movement mechanism 73 based on the warpage information, the power source 50 applies a predetermined voltage between the first electrode 51 and the second electrode 52. Accordingly, etching of the metal film 96 is performed on the target portion of the peripheral edge portion 93 (step S14). In the substrate processing apparatus 1, each portion of the peripheral edge portion 93 of the substrate 9 passes under the sensor 81 multiple times until the etching of the metal film 96 is completed. In the warpage information, for example, the amount of warpage associated with each value of the rotation angle of the substrate 9 may be updated for every measurement by the sensor 81, or the amount of warpage initially acquired may be used until the etching of the metal film 96 is completed.

When the metal film 96 has been removed from the entire peripheral edge portion 93, the application of the voltage between the electrodes 51 and 52 and the ejection of the processing liquid L1 from the processing liquid nozzle 61 are stopped, and the etching terminates. The rotation of the substrate 9 is also stopped, and the measurement by the sensor 81 and the control over the electrode movement mechanism 73 based on the warpage information terminate (step S15). Subsequent processing is the same as described in the previously-described processing example.

As described above, in the present processing example as well, the control over the electrode movement mechanism 73 based on the warpage information suppresses variations in the distances between the substrate 9 and each of the electrodes 51 and 52 and to allow proper etching to be performed on the substrate 9. Moreover, in parallel with the execution of the etching, the controller 19 acquires the warpage information through measurement by the sensor 81. This shortens the time required to acquire the warpage information and to perform etching.

In the example shown in Fig. 8, the measurement point P by the sensor 81 is set at a position that is in close proximity to the upstream side of the electrode unit 5 in the direction of rotation of the substrate 9 because the substrate 9 is rotated at a low speed. However, depending on the rotational speed of the substrate 9 or the like, the measurement point P by the sensor 81 may be arranged at a position away from the electrode unit 5 in the direction of rotation. In Fig. 8, chain double-dashed lines indicate the sensor 81 when the measurement point P is set at a position that is away by 180° from the electrode unit 5 in the direction of rotation. In the substrate processing apparatus 1, the measurement point P by the sensor 81 may be set at a position that is in close proximity to the downstream side of the electrode unit 5 in the direction of rotation. In this case, after the acquisition of the measurement value by the sensor 81, the substrate 9 is rotated slightly less than one full rotation, and then control using the measurement value is performed on the electrode movement mechanism 73. In the substrate processing apparatus 1, after the acquisition of measurement values by the sensor 81 for each portion of the peripheral edge portion 93, the position of the measurement point P by the sensor 81 with respect to the electrode unit 5 is determined so as to enable control over the electrode movement mechanism 73 based on the measurement value acquired for this portion (to ensure the movement of the electrode unit 5 in the up-down direction).

Meanwhile, in the etching of the metal film 96 on the peripheral edge portion 93, a portion of the metal film 96 that is in close proximity to the cathode is preferentially removed as described previously. In other words, a certain amount of time is required to remove a portion of the metal film 96 that is in close proximity to the anode. Thus, depending on the position where the metal film 96 adheres to, a prolonged period of time may be required to remove the entire metal film 96 existing on the peripheral edge portion 93.

Next is a description about a preferable technique for efficiently removing the entire metal film 96 existing on the peripheral edge portion 93. In the etching of the metal film 96 on the peripheral edge portion 93, after removal of a portion of the metal film 96 that is in close proximity to the first electrode 51 serving as the cathode, the auxiliary movement mechanism 711 shown in Fig. 3 slightly moves the first electrode 51 toward the substrate 9. This reduces the distance between the opposing face 511 of the first electrode 51 and the metal film 96 remaining on the peripheral edge portion 93 and accordingly shortens the time required to remove the entire metal film 96 existing on the peripheral edge portion 93.

At this time, by the auxiliary movement mechanism 711 moving the processing liquid nozzle 61 together with the first electrode 51, it becomes possible to supply the processing liquid L1 to an appropriate position between the first electrode 51 and the substrate 9 even if the first electrode 51 is brought closer to the remaining metal film 96. Depending on the design of the substrate processing apparatus 1, the auxiliary movement mechanism 711 may move only the first electrode 51. The timing when the auxiliary movement mechanism 711 moves the first electrode 51 closer to the substrate 9 is, for example, determined based on the images of the peripheral edge portion 93 acquired by the imaging capturer. This timing may also be determined based on the current flowing between the second electrode 52 and the first electrode 51, or may be a predetermined time.

Instead of or along with the movement of the first electrode 51 by the auxiliary movement mechanism 711, the power source 50 may increase the voltage applied between the first electrode 51 and the second electrode 52. This accelerates the removal of a portion of the metal film 96 that is located away from the first electrode 51. Moreover, after removal of a portion of the metal film 96 that is in close proximity to the first electrode 51 serving as the cathode, the power source 50 may invert the cathode and the anode (invert the polarities of the first electrode 51 and the second electrode 52). This makes the first electrode 51 serve as the anode and makes the second electrode 52 serve as the cathode. As a result, it becomes possible to accelerate the etching of a portion of the metal film 96 that is in close proximity to the second electrode 52 serving as the cathode and to shorten the time required to remove the entire metal film 96 remaining on the peripheral edge portion 93 (i.e., shortens the etching time). The above-described technique for shortening the etching time may be adopted in other examples.

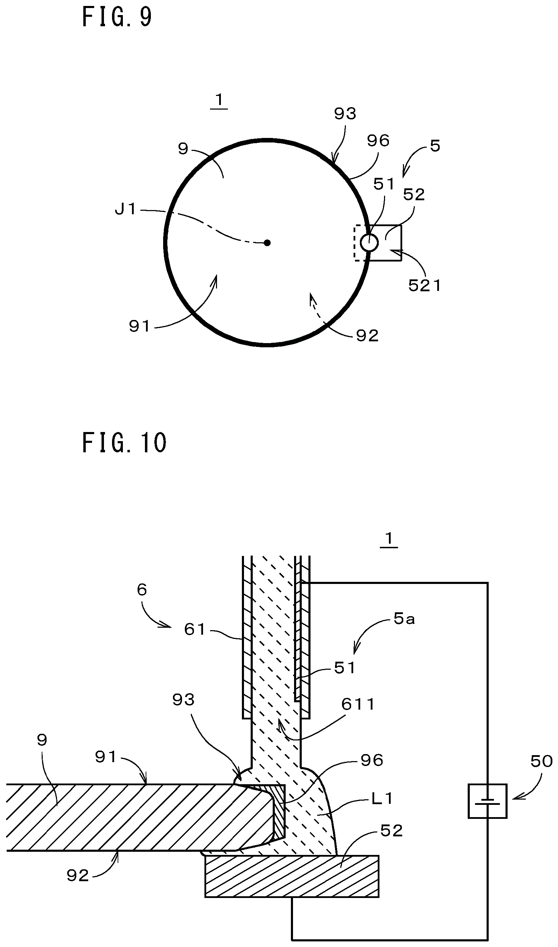

Fig. 9 is a plan view showing another example of the electrode unit 5. In the electrode unit 5 shown in Fig. 9, the second electrode 52 located on the side of the second main surface 92 of the substrate 9 has a rectangular plate-like shape. An upward face of the second electrode 52 corresponds to the opposing face 521 facing the substrate 9 and is approximately parallel to the second main surface 92 of the substrate 9. The opposing face 521 of the second electrode 52 is larger than the opposing face 511 of the first electrode 51 (see Fig. 3). The area of the opposing face 521 is, for example, twice or more of the area of the opposing face 511 and preferably three times or more. There are no particular limitations on the upper limit for the area of the opposing face 521, and the area of the opposing face 521 is, for example, ten times or less of the area of the opposing face 511 because an excessive increase in the opposing face 521 will increase the weight of the second electrode 52. When viewed in plan view, the entire first electrode 51 overlaps entirely with the second electrode 52.

As described above, the opposing face 521 of the second electrode 52 located on the side of the second main surface 92 of the substrate 9 is larger than the opposing face 511 of the first electrode 51 located on the side of the first main surface 91 of the substrate 9. This improves the properties of the second electrode 52 retaining the processing liquid L1. As a result, it becomes possible to easily maintain the liquid-filled state in which the processing liquid L1 is filled in the space among the target portion of the peripheral edge portion 93, the first electrode 51, and the second electrode 52. The large opposing face 521 of the second electrode 52 serving as the anode also accelerates reduction reactions occurring by the opposing face 521 as compared to the case of the electrode unit 5 shown in Fig. 3. This also accelerates oxidation reactions occurring by the opposing face 511 of the first electrode 51 and achieves an improvement in the etch rate of the metal film 96. In the example shown in Fig. 9 as well, the control over the electrode movement mechanism 73 based on the warpage information suppresses variations in the distances between the substrate 9 and each of the electrodes 51 and 52 and allows the etching to be properly performed on the substrate 9.

Fig. 10 is a diagram showing another example of the electrode unit, and shows cross-sections of an electrode unit 5a and the processing liquid nozzle 61. In the example shown in Fig. 10, the processing liquid nozzle 61 is a straight nozzle extending in the up-down direction and is arranged above the peripheral edge portion 93 of the substrate 9 when arranged at the processing position. For example, the processing liquid nozzle 61 is formed of an insulating material such as a resin. The first electrode 51 of the electrode unit 5a is a film formed of a conductive material and provided on the inner peripheral surface of the processing liquid nozzle 61. In other words, the processing liquid nozzle 61 is a nozzle with a built-in electrode. Similarly to the example shown in Fig. 9, the second electrode 52 has a plate-like shape. The first electrode 51 and the second electrode 52 are connected to the power source 50.

In the etching of the metal film 96 on the peripheral edge portion 93 of the substrate 9, the processing liquid L1 is continuously ejected from the ejection port 611 of the processing liquid nozzle 61. The processing liquid L1 covers the metal film 96 on the target portion of the peripheral edge portion 93 and also collides with the second electrode 52. In other words, a liquid column of the processing liquid L1 formed downward from the ejection port 611 comes into contact with both of the target portion of the peripheral edge portion 93 and the second electrode 52. In actuality, the processing liquid L1 flows around the side of the second main surface 92 of the peripheral edge portion 93 and is filled in the gap between the second electrode 52 and the peripheral edge portion 93. In this way, a liquid-filled state is maintained, in which the processing liquid L1 is filled in the space among the target portion, the first electrode 51, and the second electrode 52. The metal film 96 is etched as a result of the power source 50 applying a voltage between the first electrode 51 and the second electrode 52. Moreover, by controlling the electrode movement mechanism 73 based on the warpage information, it becomes possible to suppress variations in the distances between the substrate 9 and each of the electrodes 51 and 52 (in particular, variations in the distance between the substrate 9 and the second electrode 52) and to properly perform etching on the substrate 9.

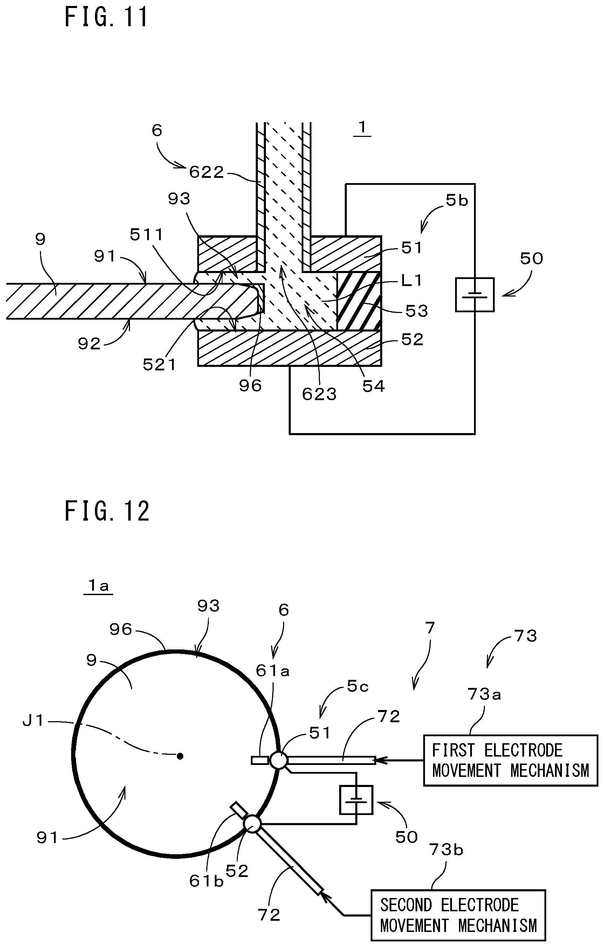

Fig. 11 is a sectional view showing another example of the electrode unit. An electrode unit 5b shown in Fig. 11 includes a first electrode 51 having a rectangular plate-like shape and a second electrode 52 having a rectangular plate-like shape. With the electrode unit 5b arranged at the processing position, the first electrode 51 is located on the side of the first main surface 91 of the substrate 9, and the second electrode 52 is located on the side of the second main surface 92 of the substrate 9. A downward face of the first electrode 51 corresponds to the opposing face 511 facing the substrate 9 and is approximately parallel to the first main surface 91 of the substrate 9. An upward face of the second electrode 52 corresponds to the opposing face 521 facing the substrate 9 and is approximately parallel to the second main surface 92 of the substrate 9. The opposing face 511 of the first electrode 51 and the opposing face 521 of the second electrode 52 are approximately parallel to each other. The distance between the first electrode 51 and the second electrode 52 is slightly greater than the thickness of the substrate 9.

The electrode unit 5b further includes an insulating member 53. For example, the insulating member 53 has a block-like shape formed of a resin and is arranged between an outer end portion of the first electrode 51 and an outer end portion of the second electrode 52 in the radial direction. The first electrode 51 and the second electrode 52 are fixedly attached to the insulating member 53. The first electrode 51 has a through hole provided radially inward of the insulating member 53. In the processing liquid line 62 (see Fig. 2) of the processing-liquid filling unit 6, a connecting member 622 is provided on an end portion on the side opposite to the processing-liquid supply source 63, and the connecting member 622 is inserted in and fixedly attached to the aforementioned through hole. The connecting member 622 has an ejection port 623 for ejecting the processing liquid L1, and the processing liquid L1 is supplied from this ejection port 623 to a space 54 surround by the insulating member 53, the first electrode 51, and the second electrode 52 (hereinafter, referred to as the "processing space 54"). In the substrate processing apparatus 1 shown in Fig. 11, the connecting member 622, the first electrode 51, the insulating member 53, and the second electrode 52 are integrally configured as a single member. The auxiliary movement mechanism 711 (see Fig. 3) is omitted from the electrode movement mechanism 73, and the electrode unit 5b is mounted on the arm part 72.

When etching is performed on the peripheral edge portion 93 of the substrate 9, the electrode unit 5b and the connecting member 622 are arranged at the processing position so that the peripheral edge portion 93 is inserted into the processing space 54 from the radially inner side. The processing liquid L1 is ejected from the ejection port 623 of the connecting member 622 so as to fill the processing space 54. That is, a liquid-filled state is formed, in which the processing liquid L1 is filled in the space among the target portion of the peripheral edge portion 93, the first electrode 51, and the second electrode 52. Then, the power source 50 applies a voltage between the first electrode 51 and the second electrode 52 so that the metal film 96 is etched. Moreover, as a result of the controller 19 controlling the electrode movement mechanism 73 in accordance with the warpage information, it becomes possible to suppress variations in the distances between the substrate 9 and each of the electrodes 51 and 52 and to properly perform etching on the substrate 9. If the liquid-filled state is maintained in the processing space 54, the processing liquid L1 may be ejected either continuously or intermittently from the ejection port 623.

As described above, the electrode unit 5b shown in Fig. 11 includes the insulating member 53 that is arranged outward of the peripheral edge portion 93 of the substrate 9 between the first electrode 51 and the second electrode 52 and that is fixedly attached to the first electrode 51 and the second electrode 52. The processing-liquid filling unit 6 supplies the processing liquid L1 from the ejection port 623 to the processing space 54 surrounded by the insulating member 53, the first electrode 51, and the second electrode 52. Accordingly, it becomes possible to form the liquid-filled state with ease and more reliability and to properly perform etching on the metal film 96 on the peripheral edge portion 93.

In the substrate processing apparatus 1, the substrate 9 does not necessarily have to be held in a horizontal position, and for example, may be held in an upright position. In the case where the substrate 9 is held in an upright position in the substrate processing apparatus 1 shown in Fig. 11, the orientation of the electrode unit 5b is changed such that the insulating member 53 is arranged below the substrate 9 in an upright position (in a state obtained by rotating Fig. 11 by 90° in the clockwise direction). In the electrode unit 5b shown in Fig. 11, the first electrode 51 may be located on one main surface side of the substrate 9 (e.g., the side of the first main surface 91), and the second electrode 52 may be located radially outward of the substrate 9. As another alternative, in the electrode unit 5b, the first electrode 51, the insulating member 53, and the second electrode 52 may be arranged side by side in the circumferential direction on one main surface side of the substrate 9 (e.g., on the side of the first main surface 91).

Meanwhile, in order to increase the etch rate of the metal film 96 on the peripheral edge portion 93, it is preferable that the first electrode 51 is located on one main surface side of the substrate 9 and the second electrode 52 is located on the other main surface side as in the electrode units 5, 5a, and 5b shown in Figs. 3, 9, 10, and 11. In this way, arranging the substrate 9 between the first electrode 51 and the second electrode 52 allows efficient etching of the metal film 96. In the above-described electrode units 5, 5a, and 5b, the entire first electrode 51 overlaps almost entirely with the second electrode 52 when viewed in a direction perpendicular to the main surfaces 91 and 92 of the substrate 9. However, the first electrode 51 and the second electrode 52 may overlap only partially with each other. The substrate processing apparatus 1 allows efficient etching of the metal film 96 by causing the first electrode 51 and the second electrode 52 to overlap at least partially when viewed in a direction perpendicular to the opposite main surfaces 91 and 92 of the substrate 9.

In the above-described substrate processing apparatus 1, the first electrode 51 and the second electrode 52 are arranged at approximately the same circumferential position. However, the first electrode 51 and the second electrode 52 may be provided at different circumferential positions. Fig. 12 is a diagram showing a substrate processing apparatus 1a according to a second embodiment. In the substrate processing apparatus 1a, both of the first electrode 51 and the second electrode 52 are arranged on the side of the first main surface 91 of the substrate 9. Specifically, with an electrode unit 5c arranged at the processing position facing the substrate 9, the first electrode 51 is located in the vicinity of the peripheral edge portion 93 on the side of the first main surface 91. The second electrode 52 is located in closer proximity to the substrate 9 while being separated from the first electrode 51 in the circumferential direction on the side of the first main surface 91. In the example shown in Fig. 12, the second electrode 52 is also located in the vicinity of the peripheral edge portion 93.

The processing-liquid filling unit 6 includes a first processing liquid nozzle 61a and a second processing liquid nozzle 61b that are provided on the side of the first main surface 91. The first processing liquid nozzle 61a is located in the vicinity of the first electrode 51 and ejects the processing liquid L1 toward the gap between the first electrode 51 and the substrate 9. The first electrode 51 is electrically connected via the processing liquid L1 to the metal film 96 on the peripheral edge portion 93. The second processing liquid nozzle 61b is located in the vicinity of the second electrode 52 and ejects the processing liquid L1 toward the gap between the second electrode 52 and the substrate 9. The second electrode 52 is electrically connected via the processing liquid L1 to the metal film 96 on the peripheral edge portion 93 at a different position from the first electrode 51. In this way, the processing-liquid filling unit 6 fills the processing liquid L1 in the gaps between the substrate 9 and each of the first electrode 51 and the second electrode 52 and provides two different (independent) points of contact for the first electrode 51 and the second electrode 52.

In the substrate processing apparatus 1a, the electrode movement mechanism 73 includes a first electrode movement mechanism 73a and a second electrode movement mechanism 73b. The first electrode movement mechanism 73a is connected to the first electrode 51 and the first processing liquid nozzle 61a via the arm part 72 and moves the first electrode 51 and the first processing liquid nozzle 61a in the up-down direction. The second electrode movement mechanism 73b is connected to the second electrode 52 and the second processing liquid nozzle 61b via the arm part 72 and moves the second electrode 52 and the second processing liquid nozzle 61b in the up-down direction.

In the etching performed by the substrate processing apparatus 1a, the power source 50 also applies a voltage between the first electrode 51 and the second electrode 52 while the substrate 9 is being rotated. In the example shown in Fig. 12, the first electrode 51 serves as the cathode, and the second electrode 52 serves as the anode. In this way, etching is performed on the metal film 96 on the peripheral edge portion 93. The first electrode movement mechanism 73a and the second electrode movement mechanism 73b are controlled based on the warpage information such that the distances between the substrate 9 and each of the first electrode 51 and the second electrode 52 are maintained approximately constant. As a result, it is possible to properly perform etching on the substrate 9. In Fig. 12, illustration of the sensor 81 is omitted.

The substrate processing apparatus 1a is also capable of performing etching on a region located inward of the peripheral edge portion 93. Meanwhile, warpage of the substrate 9 generally increases in the peripheral edge portion 93. Thus, the above-described technique for controlling the electrode movement mechanism 73 in accordance with the warpage information is particularly effective for the etching of the metal film 96 on the peripheral edge portion 93. In other words, in the substrate processing apparatus 1a, it is preferable that the electrode unit 5c arranged at the processing position faces the peripheral edge portion 93 of the substrate 9, and the warpage information indicates the amount of warpage of the peripheral edge portion 93 as in the above-described substrate processing apparatus 1.

Meanwhile, in the substrate processing apparatus 1a as well, the metal film 96 is etched in the vicinity of the first electrode 51 serving as the cathode. However, if the etching progresses to a certain extent and the second electrode 52 (anode) faces a region from which the metal film 96 has been removed, the second electrode 52 cannot electrically be connected to the metal film 96. As a result, no current flows between the first electrode 51 and the second electrode 52, which stops the progress of the etching. Also, in the case where the metal film 96 is scattered on the peripheral edge portion 93, no current flows between the first electrode 51 and the second electrode 52, which stops the progress of the etching.

In contrast, in the substrate processing apparatus 1 shown in Fig. 2, the first electrode 51 and the second electrode 52 face the target portion during etching, the target portion being part of the peripheral edge portion 93, and the processing liquid L1 is filled in the space among the target portion, the first electrode 51, and the second electrode 52. Therefore, the first electrode 51 and the second electrode 52 are electrically connected to the metal film 96 on the target portion via the same processing liquid L1, i.e., substantially a single point of contact. As a result, it is possible to properly perform etching on the metal film 96 even if there is an isolated metal film 96 or a region from which the metal film 96 has been removed. Besides, the substrate processing apparatus 1 can significantly reduce the amount of consumption of the processing liquid L1 because the processing liquid L1 is supplied to only one location on the peripheral edge portion 93. Depending on the design of the substrate processing apparatus 1 shown in Fig. 2, the substrate processing apparatus may further include, in addition to the above-described processing liquid nozzle 61, another processing liquid nozzle that supplies the processing liquid L1 in the gap between the second electrode 52 and the substrate 9 in order to more reliably form a liquid-filled state.

The substrate processing apparatuses 1 and 1a described above may be modified in various ways.

In the above-described embodiment, the substrate processing apparatuses 1 and 1a acquires the warpage information about the substrate 9 by using the sensor 81. However, warpage information about the substrate 9 may be acquired by an external device and input to the controllers 19 of the substrate processing apparatuses 1 and 1a. That is, the controller 19 may acquire the warpage information from input of the warpage information from the outside. For example, the path unit 103 in the substrate processing system 10 shown in Fig. 1 includes a sensor R1 (indicated by the broken line in Fig. 1) similar to the sensor 81. The sensor R1 is movable via a movement mechanism not shown around the entire circumference above the peripheral edge portion 93 of the substrate 9 held by the path unit 103 Accordingly, warpage information about the substrate 9 that is before transport into the substrate processing apparatuses 1 and 1a is acquired, the warpage information indicating each angular position (e.g., the angular position using a notch as a reference) and the amount of warpage of the peripheral edge portion 93 associated with the angular position. In the substrate processing apparatuses 1 and 1a, the electrode movement mechanism 73 is controlled based on the warpage information.

Like the substrate processing apparatus 1a shown in Fig. 12, the substrate processing apparatus 1 shown in Fig. 2 may include two electrode movement mechanisms that respectively move the first electrode 51 and the second electrode 52 independently of each other.

The substrate holder that holds the substrate 9 and the rotation mechanism that rotates the substrate 9 may have structures other than the chuck part 21 and the rotation mechanism 22 shown in Fig. 2. For example, multiple rollers may be aligned in the circumferential direction around the substrate 9, and some of the rollers each rotates on its axis, causing the substrate 9 to rotate on the central axis J1 while the multiple rollers hold the substrate 9 in contact with, for example, the edge end face of the substrate 9.

The substrate to be processed by the substrate processing apparatuses 1 and 1a is not limited to a semiconductor substrate, and may be a glass substrate or any other substrate.

The configurations of the above-described preferred embodiment and variations may be appropriately combined as long as there are no mutual inconsistencies.

While the invention has been shown and described in detail, the foregoing description is in all aspects illustrative and not restrictive. It is therefore understood that numerous modifications and variations can be devised without departing from the scope of the invention.

### REFERENCE SIGNS LIST

- 1, 1a: substrate processing apparatus
- 5, 5a to 5c: electrode unit
- 6: processing-liquid filling unit
- 9: substrate
- 19: controller
- 21: chuck part
- 22: rotation mechanism
- 50: power source
- 51: first electrode
- 52: second electrode
- 73: electrode movement mechanism
- 81: sensor
- 91, 92: main surfaces (of the substrate)
- 93: peripheral edge portion (of the substrate)
- 96: metal film
- 611, 623: ejection port
- L1: processing liquid
- P: measurement point

## Claims

1. A substrate processing apparatus that performs etching on a metal film on a substrate, the substrate processing apparatus comprising:
a substrate holder that holds a substrate having a disk-like shape;
a rotation mechanism that rotates said substrate together with said substrate holder;
an electrode unit that includes a first electrode and a second electrode and that is arranged at a processing position facing said substrate during etching;
a processing-liquid filling unit that fills gaps between said first electrode and said substrate and between said second electrode and said substrate with a processing liquid;
a power source that applies a voltage between said first electrode and said second electrode;
an electrode movement mechanism that moves said first electrode and said second electrode in a direction perpendicular to main surfaces of said substrate; and
a controller that acquires warpage information about said substrate and controls said electrode movement mechanism during said etching in accordance with said warpage information and a rotation angle of said substrate, the rotation angle being input from said rotation mechanism.

2. The substrate processing apparatus according to claim 1, further comprising:
a sensor that measures, at a predetermined circumferential position, a position of said substrate in a direction perpendicular to the main surfaces of said substrate,
wherein a measurement value obtained by said sensor is input to said controller to allow said controller to acquire said warpage information.

3. The substrate processing apparatus according to claim 2, wherein
after said warpage information is acquired through measurement by said sensor while said rotation mechanism is rotating said substrate, said controller causes the substrate processing apparatus to perform said etching.

4. The substrate processing apparatus according to claim 3, wherein
a circumferential position of said electrode unit arranged at said processing position is the same as a circumferential position of a measurement point on said substrate by said sensor.

5. The substrate processing apparatus according to claim 2, wherein
in parallel with execution of said etching, said controller acquires said warpage information through measurement by said sensor.

6. The substrate processing apparatus according to any one of claims 1 to 5, wherein
said electrode unit arranged at said processing position faces a peripheral edge portion of said substrate, and
said warpage information indicates an amount of warpage of said peripheral edge portion.

7. The substrate processing apparatus according to claim 6, wherein
said electrode unit arranged at said processing position faces a target portion that is part of said peripheral edge portion, and
said processing-liquid filling unit forms a liquid-filled state by ejecting said processing liquid from an ejection port, the liquid-filled state being a state in which said processing liquid is filled in a space among said target portion, said first electrode, and said second electrode.

8. The substrate processing apparatus according to claim 7, wherein
said first electrode and said second electrode overlap at least partly when said first electrode is located on one main surface side of said substrate, said second electrode is located on the other main surface side of said substrate, and said first electrode and said second electrode are viewed in a direction perpendicular to both of the main surfaces of said substrate.
